# EUROPEAN PATENT APPLICATION

(11) **EP 3 422 566 A1**
(43) Date of publication of application: **02.01.2019**
(21) Application number: 17382408.7
(22) Date of filing: 28.06.2017
(51) Int. Cl.: H03D 1/06, H04B 1/10, H04L 27/26

(54) **SUPERHETERODYNE RADIO RECEIVER**

(71) Applicant: Airbus Defence and Space SA, 28906 Getafe Madrid (ES)
(72) Inventor: PÉREZ POMARES, José Francisco, 28906 Getafe (ES); ARRIBAS SÁNCHEZ, Víctor, 28906 Getafe (ES)
(74) Representative: Elzaburu S.L.P.

(57) **Abstract**

Superheterodyne radio receiver (1), comprising a circuit with the following elements:
- antenna (2),
- RF amplifier (3),
- mixer (4),
- local oscillator (5),
- fixed IF filter (6),
- IF amplifier (7),
- demodulator (8),
- audio amplifier (9),
and additionally comprising a variable IF filter (11) between the IF amplifier (7) and the demodulator (8), and a reflection detector (10) coupled to the variable IF filter (11) and arranged in parallel with the rest of the circuit downstream the IF amplifier (7), the variable IF filter (11) being a programmable notch filter in terms of centre frequency and bandwidth.

## Description

### Field of the invention

This invention refers to a superheterodyne radio receiver, which is mainly used in air to air communications.

### Background of the invention

Most civil and military VHF and UHF radios (V/UHF radios) use a superheterodyne architecture, including a fixed Intermediate Frequency (IF) filter in order to achieve the desired selectivity. This IF filter is a pass band filter passing the carrier information and the modulated side bands.

Examples of this conventional superheterodyne architecture can be found in the prior art broadband receivers.

US 2016126988 A1 refers to a "Broadband superheterodyne receiver with agile intermediate frequency for interference mitigation" that discloses embodiments including an input for receiving a Radio Frequency (RF) signal including an RF data signal at a carrier frequency. An RF mixer coupled to the input shifts the RF data signal from the carrier frequency to an IF frequency. An IF band pass filter coupled to the mixer has a pass band, and band pass filters the signal near the IF frequency. A spectrum analyzer provides information representative of the spectral characteristics of the received RF signal around the RF data signal at the carrier frequency. An IF controller is coupled to the RF mixer and to the spectrum analyzer. The IF controller determines an interference-mitigating IF frequency within the pass band of the band pass filter that will result in attenuation of undesired portions of the RF signal, and controls the RF mixer to shift the RF data signal to the interference-mitigating IF frequency.

US 2008089443 A1 refers to a "Wireless communication apparatus" for receiving a packet formed of a signal modulated by orthogonal frequency division multiplexing, comprising a band-pass filter that extracts an orthogonal-frequency-division-multiplexing (OFDM) signal of a desired band; a low-noise amplifier having a gain controlled according to a received-signal intensity to amplify the OFDM signal of the desired band; a frequency converter that down-converts the amplified OFDM signal into a baseband signal; an analog-digital converter that converts the baseband signal into a digital signal; a first high-pass filter that removes a DC offset from the baseband signal corresponding to a predetermined preamble portion of the packet; a frequency-offset estimator that estimates a frequency offset from sample signals constituting the baseband signal from which the DC offset has been removed by the first high-pass filter; a frequency-offset corrector that removes the estimated frequency offset from the baseband signal; and a demodulator that demodulates subcarrier signals arranged in a frequency domain from the baseband signal compensated for the frequency offset.

Current superheterodyne V/UHF radios suffer, in air to air communications, from interfering noises and missing calls due to multipath effects. Here are some of the effects that can be produced:
- Specular reflections:
   ∘ At long distances there is a Noise Floor Modulation effect (similar to a railway steam engine starting up).
   ∘ At medium to short distances there is an Audio Tone which increases pitch, as distance reduces (it is similar to a racing car at short distances). At medium distances the noise comes together with Distortion (similar to an echo).
- Scattered reflections:
   ∘ At all distances it causes a Wide Noise with wide spectrum (similar to the wind noise).

In digital communications, the result could be a missing call.

Current airborne superheterodyne V/UHF radios use the frequency response of the Automatic Gain Control (AGC) in order to limit the Noise Floor Modulation effect and the Audio Tone effect.

However, current civil and military aircraft suffer from multipath problems, particularly when using antennas on the aircraft belly.

Accordingly, there is a need to provide a superheterodyne radio receiver that is able to remove most of the described effects that can be produced in air to air communications and most of missing calls in digital transmissions.

### Summary of the invention

The object of the present invention is to improve air to air communications, removing most of the multipath problems and effects of the prior art configurations.

The invention provides a superheterodyne radio receiver, comprising a circuit with the following elements:
- antenna,
- RF amplifier,
- mixer,
- local oscillator,
- fixed IF filter,
- IF amplifier,
- demodulator,
- audio amplifier,
and additionally comprising a variable IF filter between the IF amplifier and the demodulator, and a reflection detector coupled to the variable IF filter and arranged in parallel with the rest of the circuit downstream the IF amplifier, the variable IF filter being a programmable notch filter in terms of centre frequency and bandwidth.

The configuration of the superheterodyne radio receiver of the invention allows removing most of the described effects that can be produced in air to air communications and most of missing calls in digital transmissions.

Another advantage of the invention is that the end user of a civil or military aircraft can notice a remarkable performance improvement in air to air communications, particularly when using antennas on the aircraft belly. The improvement can be the possibility to read a message that was not possible to read with the previous architectures. When using digital communications, the difference can be to receive or not to receive the call.

Other characteristics and advantages of the present invention will be clear from the following detailed description of embodiments illustrative of its object in relation to the attached figures.

### Brief description of drawings

Figure 1 shows the block diagram of a circuit corresponding to a conventional superheterodyne architecture.
Figure 2 shows the block diagram of a circuit corresponding to the architecture of the superheterodyne radio receiver of the invention.

### Detailed description of the invention

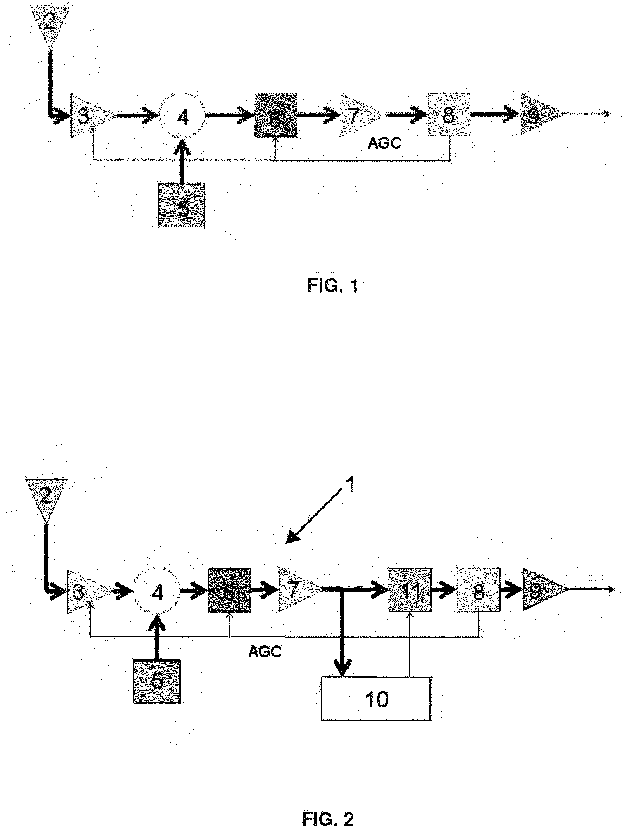

Figure 1 shows the architecture of a conventional superheterodyne radio receiver. In this circuit an antenna 2 receives a transmitted signal and provides it to an RF amplifier 3, which amplifies the received signal and provides it to a mixer 4. The mixer 4 receives an input from a local oscillator 5, whose frequency translates the incoming signal in a frequency such that the desired station frequency falls within the pass band of a fixed IF filter 6, thus allowing selection of the desired channel. The fixed IF filter 6 is coupled to an IF amplifier 7, which amplifies the desired channel and provides it to a demodulator 8, which is coupled to an audio amplifier 9.

The superheterodyne radio receiver of figure 1 uses the frequency response of the AGC (Automatic Gain Control) in order to limit the Noise Floor Modulation effect, and the Audio Tone effect.

Figure 2 shows a circuit corresponding to the architecture of the superheterodyne radio receiver 1 of the invention. In the block diagram of figure 2 it can be seen that the circuit additionally comprises a variable IF filter 11 between the IF amplifier 7 and the demodulator 8, and a reflection detector 10 coupled to the variable IF filter 11 and arranged in parallel with the rest of the circuit downstream the IF amplifier 7. The variable IF filter 11 is controlled by the reflection detector 10.

The variable IF filter 11 removes the majority of the Noise Floor Modulation effect, the majority of the Audio Tone effect, the majority of the Distortion effect, the majority of the Wise Noise effect and the majority of missing calls in digital transmissions.

The reflection detector 9 of the circuit of figure 2 monitors:
- where the direct carrier is with respect to the channel centre frequency,
- where the specular reflection carrier is with respect to the direct carrier, and
- if there are specular reflections and where they are with respect to the channel centre frequency.

The main features of the variable IF filter 11 of figure 2 are the following ones:
- It is a programmable notch filter in terms of centre frequency and bandwidth.
- The programming algorithm is based on the inputs provided by the reflection detector.
- It can be applied to the upper side band
- It can be applied to the lower side band.
- It can be applied to the central part of the channel.

Thus the invention uses the variable IF filter 11 based on a programmable (in central frequency and bandwidth) notch filter within the intermediate frequency of a superheterodyne radio to:
- Supress part of the Upper Side Band
- Supress part of the Lower Side Band
- Suppress the central part of the channel.

The invention also uses the reflection detector 10 to locate the direct carrier, and the specular and scattered reflections.

As shown in figure 2, the superheterodyne radio receiver 1 of the invention may also comprise an Automatic Gain Control closed-loop feedback regulating circuit (AGC).

Although the present invention has been fully described in connection with preferred embodiments, it is evident that modifications may be introduced within the scope thereof, not considering this as limited by these embodiments, but by the contents of the following claims.

## Claims

1. Superheterodyne radio receiver (1), comprising a circuit with the following elements:
- antenna (2),
- RF amplifier (3),
- mixer (4),
- local oscillator (5),
- fixed IF filter (6),
- IF amplifier (7),
- demodulator (8),
- audio amplifier (9),
**characterized in that** the circuit additionally comprises a variable IF filter (11) between the IF amplifier (7) and the demodulator (8), and a reflection detector (10) coupled to the variable IF filter (11) and arranged in parallel with the rest of the circuit downstream the IF amplifier (7), the variable IF filter (11) being a programmable notch filter in terms of centre frequency and bandwidth.
